# EUROPEAN PATENT APPLICATION

(11) **EP 4 148 787 A2**
(43) Date of publication of application: **15.03.2023**
(21) Application number: 22191132.4
(22) Date of filing: 19.08.2022
(51) Int. Cl.: H01L 23/66

(54) **ELECTRONIC DEVICE AND MANUFACTURING METHOD THEREOF**

(30) Priority: 10.09.2021 US 202163242496 P; 14.06.2022 CN 202210669529
(71) Applicant: InnoLux Corporation, Chu-Nan, Miao-Li County 35053 (TW)
(72) Inventor: CHI, Jen-Hai, 35053 Chu-Nan, Miao-Li County (TW); HO, Chia-Chi, 35053 Chu-Nan, Miao-Li County (TW)
(74) Representative: Becker, Eberhard

(57) **Abstract**

An electronic device includes a substrate, a bump, a chip, and an adhesive layer. The substrate includes a first connection pad. The bump is disposed on the first connection pad. The chip includes a second connection pad. The bump is disposed between the first connection pad and the second connection pad. The adhesive layer is disposed between the substrate and the chip. A dissipation factor of the adhesive layer is less than or equal to 0.01 at a frequency of 10GHz. A manufacturing method of an electronic device includes the following: providing a substrate, where the substrate includes a first connection pad; applying an adhesive layer on the substrate; patterning the adhesive layer, such that the adhesive layer produces an opening exposing the first connection pad; forming a bump on the first connection pad; and bonding the chip onto the bump through the second connection pad.

## Description

### BACKGROUND

### Technical Field

The disclosure relates to an electronic device and a manufacturing method thereof, and in particular, relates to an electronic device capable of providing improved reliability or relates to an electronic device and a manufacturing method thereof suitable for high frequency or radio signal transmission.

### Description of Related Art

Electronic devices or splicing electronic devices have been widely applied in different fields such as communication, display, vehicle, or aviation. With the vigorous advancement of electronic devices, the development of the electronic devices moves towards thinness and lightness. Therefore, the requirements for reliability and quality of the electronic devices continue to grow.

### SUMMARY

The disclosure provides an electronic device and a manufacturing method thereof capable of providing improved reliability of the electronic device or suitable for high frequency or radio signal transmission.

According to an embodiment of the disclosure, an electronic device includes a substrate, a bump, a chip, and an adhesive layer. The substrate includes a first connection pad. The bump is disposed on the first connection pad. The chip includes a second connection pad. The bump is disposed between the first connection pad and the second connection pad. The adhesive layer is disposed between the substrate and the chip. A dissipation factor of the adhesive layer is less than or equal to 0.01 at a frequency of 10GHz.

According to an embodiment of the disclosure, a manufacturing method of an electronic device includes the following steps. A substrate is provided. The substrate includes a first connection pad. An adhesive layer is applied on the substrate. The adhesive layer is patterned, such that the adhesive layer produces an opening exposing the first connection pad. A bump is formed on the first connection pad. A chip is provided. The chip includes a second connection pad. The chip is bonded onto the bump through the second connection pad.

### BRIEF DESCRIPTION OF THE DRAWINGS

The accompanying drawings are included to provide a further understanding of the disclosure, and the accompanying drawings are incorporated in and constitute a part of this specification. The drawings illustrate the embodiments of the disclosure, and together with the description, serve to explain the principle of the disclosure.
FIG. 1A to FIG. 1D are cross-sectional schematic views of a manufacturing method of an electronic device according to an embodiment of the disclosure.
FIG. 2A to FIG. 2B are cross-sectional schematic views of a manufacturing method of an electronic device according to another embodiment of the disclosure.
FIG. 3 is a cross-sectional schematic view of an electronic device according to an embodiment of the disclosure.
FIG. 4 is a cross-sectional schematic view of an electronic device according to another embodiment of the disclosure.
FIG. 5 is a cross-sectional schematic view of an electronic device according to another embodiment of the disclosure.
FIG. 6 is a cross-sectional schematic view of an electronic device according to another embodiment of the disclosure.

### DESCRIPTION OF THE EMBODIMENTS

The accompanying drawings are included together with the detailed description provided below to provide a further understanding of the disclosure. Note that in order to make the drawings to be more comprehensible to readers and for the sake of clarity of the drawings, only part of the electronic device is depicted in the drawings of the disclosure, and specific elements in the drawings are not depicted according to actual scales. In addition, the numbers and sizes of the elements in each drawing are provided for illustration only and are not used to limit the scope of the disclosure.

In the following specification and claims, the words "containing" and "including" are open-ended words and therefore should be interpreted as "containing but not limited to...".

It should be understood that when an element or a film layer is referred to as being "on" or "connected to" another element or film layer, it can be directly on the another element or film layer or be directly connected to the another element or film layer, or an inserted element or film layer may be provided therebetween (not a direct connection). In contrast, when the element is referred to as being "directly on" another element or film layer or "directly connected to" another element or film layer, an inserted element or film layer is not provided therebetween.

Although the terms "first", "second", "third"...may be used to describe various constituent elements, the constituent elements are not limited to these terms. These terms are only used to distinguish a single constituent element from other constituent elements in the specification. The same terms may not be used in the claims, and the elements in the claims may be replaced with first, second, third... according to the order declared by the elements in the claims. Therefore, in the following description, the first constituent element may be the second constituent element in the claims.

In the text, the terms "about", "approximately", "substantially", and "roughly" usually mean within 10%, 5%, 3%, 2%, 1%, or 0.5% of a given value or range. The number given here is an approximate number, that is, the meanings of "about", "approximately", "substantially", and "roughly" may still be implied without specifying "about", "approximately", "substantially", and "roughly".

In some embodiments of the disclosure, regarding the words such as "connected", "interconnected", etc. referring to bonding and connection, unless specifically defined, these words mean that two structures are in direct contact or two structures are not in direct contact, and other structures are provided to be disposed between the two structures. The word for joining and connecting may also include the case where both structures are movable or both structures are fixed. In addition, the word "coupled" may include any direct or indirect electrical connection means.

In some embodiments of the disclosure, an optical microscopy (OM), a scanning electron microscope (SEM), a film thickness profile measuring instrument (a-step), an elliptical thickness measuring instrument, or other suitable methods may be adopted to measure the area, width, thickness, or height of each element or to measure the distance or spacing between elements. In detail, according to some embodiments, the scanning electron microscope may be used to obtain a cross-sectional structural image of an element to be measured, and to measure the area, width, thickness, or height of each element, or the distance or spacing between elements. In some embodiments of the disclosure, the resonator cavity method may be used to perform material measurement to obtain a dissipation factor Df and a dielectric constant Dk of the material, so as to understand the material properties.

The electronic device of the disclosure may include but not limited to a display device, a backlight device, an antenna device, a sensing device, or a splicing device. The electronic device may be a bendable or flexible electronic device. The display device may be a non-self-luminous display device or a self-luminous display device. The antenna device may be a liquid crystal antenna device or a non-liquid crystal antenna device, and the sensing device may be a sensing device that senses capacitance, light, heat, or ultrasound, but it is not limited thereto. The electronic element in the electronic device may include a passive element and an active element, such as a capacitor, a resistor, an inductor, a diode, a transistor, etc. The diode may include a light emitting diode (LED) or a photodiode. The light emitting diode may include but not limited to an organic LED (OLED), a sub-millimeter LED (mini LED), a micro LED, or a quantum dot LED. The splicing device may be, for example, a display splicing device or an antenna splicing device, but it is not limited thereto. Note that the electronic device may be any combination of the foregoing, but it is not limited thereto. Hereinafter, the disclosure is described with an electronic device.

It should be understood that in the following embodiments, the features of several different embodiments may be replaced, recombined, and mixed to complete other embodiments without departing from the spirit of the disclosure. As long as the features of the embodiments do not violate or do not conflict with the spirit of the disclosure, they may be mixed and matched arbitrarily.

Descriptions of the disclosure are given with reference to the exemplary embodiments illustrated by the accompanying drawings. Wherever possible, the same reference numbers are used in the drawings and the description to refer to the same or like parts.

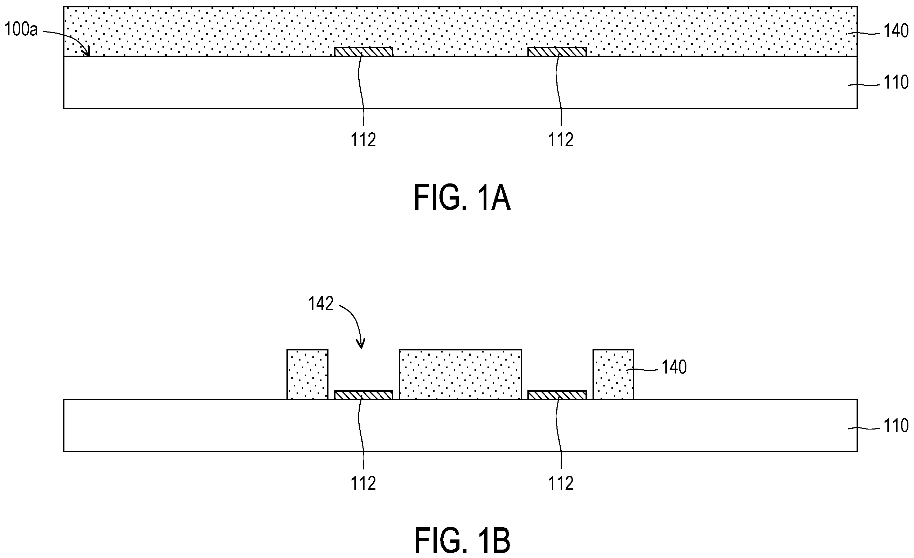

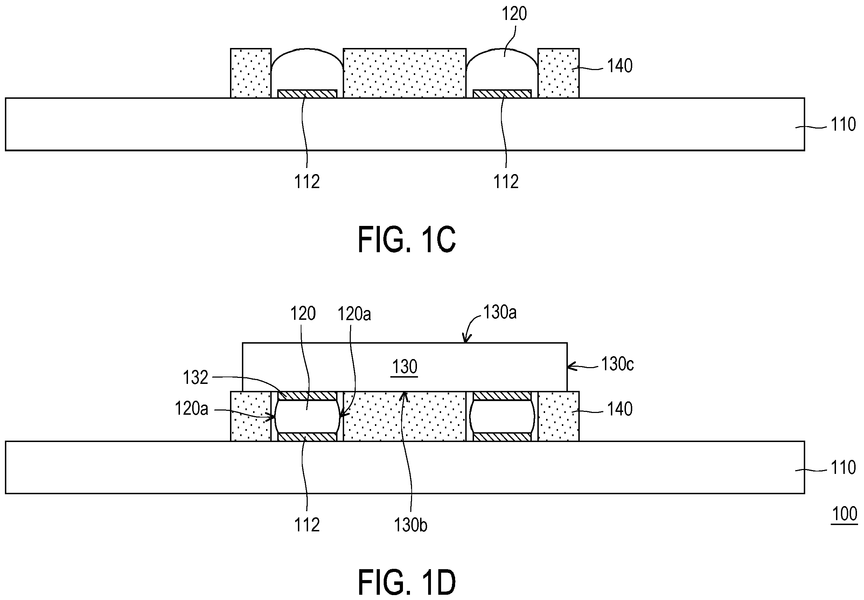

FIG. 1A to FIG. 1D are cross-sectional schematic views of a manufacturing method of an electronic device according to an embodiment of the disclosure. With reference to FIG. 1D first, an electronic device 100 provided by this embodiment may include a substrate 110, a bump 120, a chip 130, and an adhesive layer 140. The substrate 110 includes a first connection pad 112. The bump 120 is disposed on the first connection pad 112. The chip 130 includes a second connection pad 132. The bump 120 is disposed between the first connection pad 112 and the second connection pad 132. The adhesive layer 140 is disposed between the substrate 110 and the chip 130. A material of the first connection pad 112 may include but not limited to copper, nickel, other suitable metal materials, or a combination of the foregoing.

A manufacturing method of the electronic device 100 provided by this embodiment is described below, and the manufacturing method of the electronic device 100 may include but not limited to the following steps.

First, with reference to FIG. 1A, the substrate 110 is provided. In this embodiment, the substrate 110 may include the first connection pad 112 disposed on a surface 110a of the substrate 110. The surface 110a is the surface of the substrate 110 facing the chip 130. In this embodiment, the substrate 110 may be, for example, a rigid substrate, a flexible substrate, or a combination of the foregoing. For instance, a material of the substrate 110 may include but not limited to glass, quartz, sapphire, ceramics, polycarbonate (PC), polyimide (PI), polyethylene terephthalate (PET), other suitable substrate materials, or a combination of the foregoing materials.

Next, with reference to FIG. 1A again, the adhesive layer 140 is applied on the surface 110a of the substrate 110. The adhesive layer 140 may cover the first connection pad 112 and the substrate 110. In this embodiment, a material of the adhesive layer 140 may include but not limited to at least one of alkane, olefin, ether, nitro, dimethylamine, and parylene, for example. Besides, in this embodiment, since the dissipation factor (Df) of the adhesive layer 140 can be, for example, less than or equal to 0.01 (i.e., Df < 0.01 or Df = 0.01) at a frequency of 10 gigahertz (GHz), the electronic device 100 is suitable for high frequency or radio signal transmission, but it is not limited thereto. In some embodiments, the dissipation factor of the adhesive layer can also be less than or equal to 0.008 at a frequency of 10 GHz. In some other embodiments, the dissipation factor of the adhesive layer can also be less than or equal to 0.005 at a frequency of 10 GHz.

In this embodiment, since the dielectric constant (Dk) of the adhesive layer 140 can be, for example, less than or equal to 3.8 (i.e., Dk < 3.8 or Dk = 3.8) at a frequency of 10 GHz, the electronic device 100 is suitable for high frequency or radio signal transmission, but it is not limited thereto. In some embodiments, the dielectric constant of the adhesive layer can also be less than or equal to 3.5 at a frequency of 10 GHz.

Next, with reference to FIG. 1B, the adhesive layer 140 is patterned, such that the adhesive layer 140 produces an opening 142 exposing the first connection pad 112. In this embodiment, the method of patterning the adhesive layer 140 may include but not limited to one of a photolithography method, a laser drilling method, a screen printing method, and a spin method, for example. Herein, the opening 142 of the adhesive layer 140 may expose the first connection pad 112, and the size of the opening 142 may be, for example, greater than the size of the first connection pad 112, but it is not limited thereto. In some embodiments, the size of the opening may be less than or equal to the size of the first connection pad (not shown).

Next, with reference to FIG. 1C, after the adhesive layer 140 is patterned, the bump 120 is formed on the first connection pad 112. The bump 120 may contact the first connection pad 112. In this embodiment, the bump 120 may be formed on the first connection pad 112 through, for example, a printing process or an inkjet printing process (dispenser), but it is not limited thereto. A material of the bump 120 may include but not limited to a solder and a flux, for example.

Next, with reference to FIG. 1D, the chip 130 is provided, and the chip 130 may include the second connection pad 132. After the bump 120 is formed on the first connection pad 112, the chip 130 is bonded onto the bump 120 through the second connection pad 132. Therefore, the bump 120 is located between the first connection pad 112 of the substrate 110 and the second connection pad 132 of the chip 130. To be specific, after the adhesive layer 140 is patterned and the chip 130 is placed on the bump 120 in a flip-chip manner, a reflow process and a curing process are performed to aggregate the solder in the bump 120 and to allow the bump 120 to wet and contact the first connection pad 112 of the substrate 110 and the second connection pad 132 of the chip 130. Herein, the chip has an upper surface 130a, a lower surface 130b opposite to the upper surface 130a, and a side surface 130c connected to the upper surface 130a and the lower surface 130b. The second connection pad 132 is disposed on the lower surface 130b of the chip 130, and the lower surface 130b is the surface of the chip 130 facing the substrate 110. A material of the second connection pad 132 may include but not limited to copper, nickel, other suitable metal materials, or a combination of the foregoing.

Next, after the reflow process is performed, a pressing process or a vacuuming process is performed to increase the bonding strength between the chip 130 and the substrate 110. In this embodiment, the adhesive layer 140 is located between the chip 130 and the substrate 110. Therefore, by adhering the chip 130 and the substrate 110 together by the adhesive layer 140, the bonding strength and stability between the chip 130 and the substrate 110 may be increased, two lateral sides 120a of the bump 120 may be surrounded by the adhesive layer 140, so that the contact between the bump 120 and water and oxygen is reduced, and the reliability of the electronic device 100 is thereby improved.

In this embodiment, compared to a general underfill, since the size of the adhesive layer 140 may be precisely controlled through a patterning method, it is easier to achieve a fine pitch. Besides, compared to a general underfill, since the thickness of the adhesive layer 140 features better uniformity, the distance between the chip 130 and the substrate 110 exhibits better uniformity as well, such that the tiling of the chip 130 may be improved or the variation of the tilt angle may be reduced.

In this embodiment, the chip 130 may be fabricated from, for example, a silicon wafer, an III-V compound (e.g., gallium arsenide (GaAs), gallium nitride (GaN), silicon carbide (SiC)), sapphire, or a glass wafer, but it is not limited thereto. The chip 130 can also be, for example, a semiconductor package element, including but not limited to a ball grid array (BGA) package, a chip scale package (CSP), and a 2.5D/3D package, but it is not limited thereto. The chip 130 may include but not limited to, for example, an integrated circuit (IC), a transistor, a silicon controlled rectifier (SCR), a valve, a thin film transistor, a capacitor, an inductor, a variable capacitor, a filter, a resistor, a diode, a light emitting diode, a microelectromechanical system (MEMS), a liquid crystal chip, a connector, an interposer, a redistribution layer, or the like. Manufacturing of the electronic device 100 of this embodiment is substantially completed so far.

Other embodiments are described for illustration in the following. It should be noted that the reference numerals and a part of the contents in the previous embodiment are used in the following embodiments, in which identical reference numerals indicate identical or similar components, and repeated description of the same technical contents is omitted. Please refer to the description of the previous embodiments for the omitted content, which will not be repeated hereinafter.

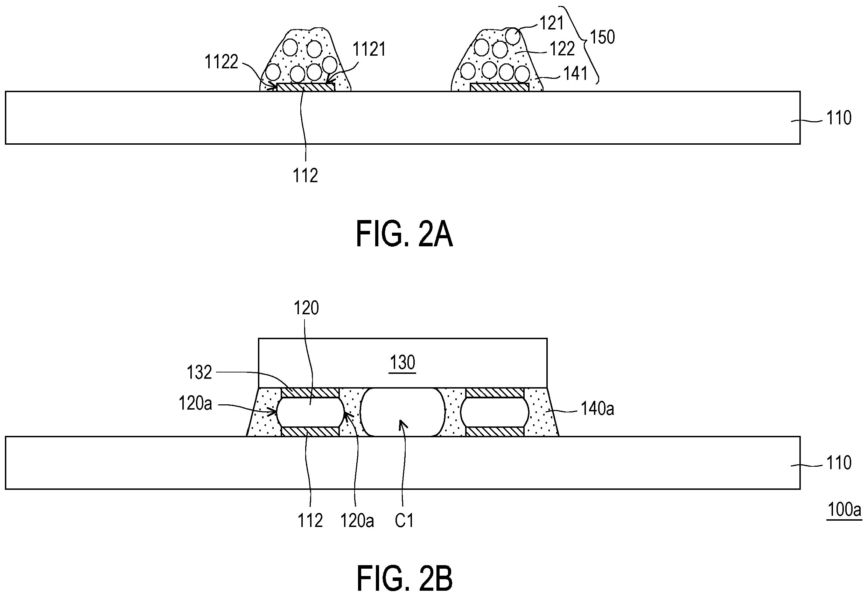

FIG. 2A to FIG. 2B are cross-sectional schematic views of a manufacturing method of an electronic device according to another embodiment of the disclosure. The embodiment shown in FIG. 2A to FIG. 2B is similar to the embodiment shown in FIG. 1A to FIG. 1D, and therefore, the same elements are denoted by the same reference numerals, and details thereof are not repeated herein. The difference between the embodiment shown in FIG. 2A to FIG. 2B and the embodiment shown in FIG. 1A to FIG. 1D is that: in a manufacturing method of an electronic device 100a of this embodiment, before the bump 120 is formed, an adhesive material 141, a plurality of solders 121, and a flux 122 are mixed into a polymer solder paste 150.

To be specific, with reference to FIG. 2A, in the manufacturing method of the electronic device 100a of this embodiment, the polymer solder paste 150 is applied on the first connection pad 112 of the substrate 110, so that the polymer solder paste 150 may cover a top surface 1121 and a side surface 1122 of the first connection pad 112. Herein, the size of the plurality of solders 121 is, for example, 1/2 times to 1/10 times the size of the first connection pad 112, but it is not limited thereto. In this embodiment, the polymer solder paste 150 may be applied on the first connection pad 112 of the substrate 110 through, for example, a printing process or an inkjet printing process, but it is not limited thereto.

Next, with reference to FIG. 2B, the chip 130 is bonded onto the bump 120 through the second connection pad 132. To be specific, after the chip 130 is placed on the polymer solder paste 150 in a flip-chip manner, a reflow process and a curing process are performed to aggregate the solders 121 in the polymer solder paste 150 into the bump 120 and to allow the bump 120 to wet and contact the first connection pad 112 of the substrate 110 and the second connection pad 132 of the chip 130. The adhesive material 141 in the polymer solder paste 150 is also cured into an adhesive layer 140a at this time, such that the two lateral sides 120a of the bump 120 may be in contact and may be surrounded by the adhesive layer 140a, the contact between the bump 120 and water and oxygen is thereby reduced, and the reliability of the electronic device 100a is improved.

In addition, in this embodiment, a cavity C1 is provided between two adjacent bumps 120. Herein, the cavity C1 may be surrounded and defined by two adjacent bumps 120, the chip 130, and the substrate 110. Manufacturing of the electronic device 100a of this embodiment is substantially completed so far.

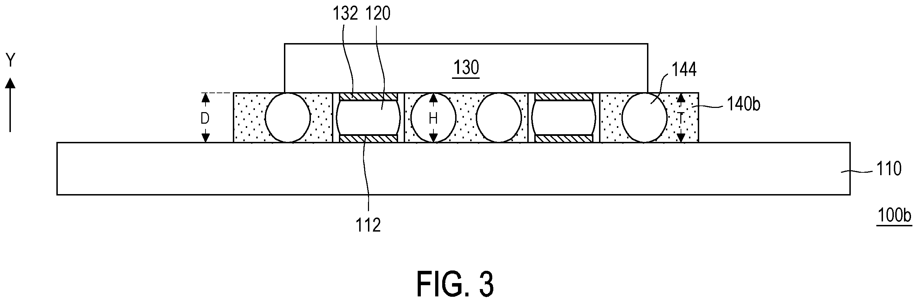

FIG. 3 is a cross-sectional schematic view of an electronic device according to an embodiment of the disclosure. With reference to FIG. 1D and FIG. 3 together, an electronic device 100b in this embodiment is similar to the electronic device 100a in FIG. 1D, but the difference therebetween is that: in the electronic device 100b of this embodiment, at least one spacer 144 may also be included, and the spacer 144 is disposed in an adhesive layer 140b.

To be specific, with reference to FIG. 3, in this embodiment, the spacer 144 is disposed between the lower surface 130b of the chip 130 and the surface 110a of the substrate 110, so as to support the chip 130 and to improve the tilting of the chip 130 or to reduce the variation of the tilt angle. Herein, the spacer 144 may overlap the chip 130 in a normal direction Y of the substrate 110. In addition, in this embodiment, a material of the spacer 144 may be, for example, silicon dioxide (SiO₂) or other suitable filling materials, but it is not limited thereto.

In this embodiment, when a distance D between the chip 130 and the substrate 110 is A, a height H of the spacer 144 may be 0.8 to 1.2 times A (i.e., 0.8×A≤H≤1.2×A), and a thickness T of the adhesive layer 140b may be 1 to 1.2 times A (i.e., 1×A≤T≤1.2×A), but it is not limited thereto. Herein, the distance D is, for example, the minimum distance measured in the normal direction Y of the substrate 110 between the chip 130 and the substrate 110. The height H is, for example, the minimum height measured in the normal direction Y of the substrate 110 when the spacer 144 is not pressed. In some embodiments, after the spacer 144 is pressed by the chip 130 and the substrate 110, the height H of the spacer 144 may be approximately equal to, for example, the distance D between the chip 130 and the substrate 110. The thickness T is, for example, the minimum thickness measured in the normal direction Y of the substrate 110 when the adhesive layer 140b is not pressed. In some embodiments, after the adhesive layer 140 is pressed by the chip 130 and the substrate 110, the thickness T of the adhesive layer 140b may be approximately equal to, for example, the distance D between the chip 130 and the substrate 110.

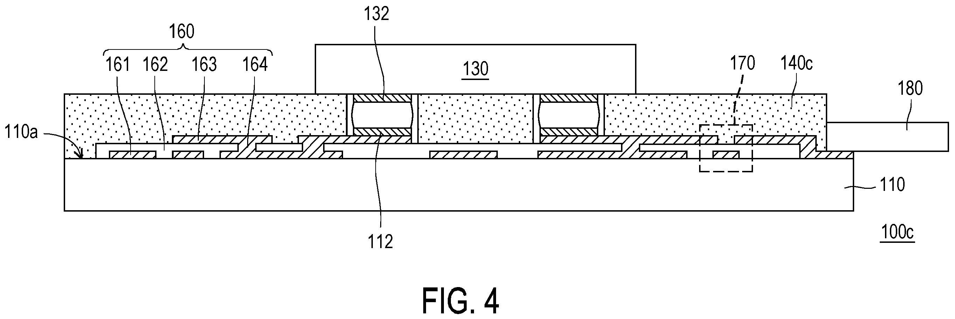

FIG. 4 is a cross-sectional schematic view of an electronic device according to an embodiment of the disclosure. With reference to FIG. 1D and FIG. 4 together, an electronic device 100c in this embodiment is similar to the electronic device 100a in FIG. 1D, but the difference therebetween is that: the electronic device 100c of this embodiment further includes a redistribution layer 160, an electronic element 170, and/or a driver element (or referred to as a controller) 180.

To be specific, with reference to FIG. 4, in this embodiment, the redistribution layer 160 is disposed on the surface 110a of the substrate 110, and the redistribution layer 160 may include but not limited to a first circuit layer 161, an insulating layer 162, a second circuit layer 163, and a conductive via 164. Herein, the first circuit layer 161 is disposed on the surface 110a of the substrate 110. The insulating layer 162 is disposed on the first circuit layer 161 to cover the first circuit layer 161 and part of the substrate 110. The second circuit layer 163 is disposed on the insulating layer 162. The conductive via 164 penetrates through the insulating layer 162 to electrically connect the first circuit layer 161 and the second circuit layer 163.

The electronic element 170 may be, for example, a transistor and is disposed in the redistribution layer 160. In some embodiments, the electronic element may also be a valve, a thin film transistor, a capacitor, an inductor, or a filter (not shown).

The driver element 180 may be attached to the edge of the substrate 110, and the driver element 180 may be electrically connected to the electronic element 170 through the redistribution layer 160. Herein, the driver element 180 may be, for example, an integrated circuit, a flexible printed circuit board (FPC), a printed circuit board (PCB), a chip on board (COB), or a chip on film (COF), but it is not limited thereto.

In this embodiment, the first connection pad 112 is disposed on the second circuit layer 163 of the redistribution layer 160, and the first connection pad 112 may be electrically connected to the redistribution layer 160.

In this embodiment, an adhesive layer 140c is disposed on the second circuit layer 163 of the redistribution layer 160 to cover the exposed circuit (e.g., the second circuit layer 163) and the electronic element 170. Therefore, in this embodiment, the adhesive layer 140c may act as a protective layer to surround the redistribution layer 160 and the electronic element 170, so that the contact between the redistribution layer 160 and the electronic element 170 between water, moisture, oxygen, and foreign matters is reduced, and the reliability of the electronic device 100c is thereby improved.

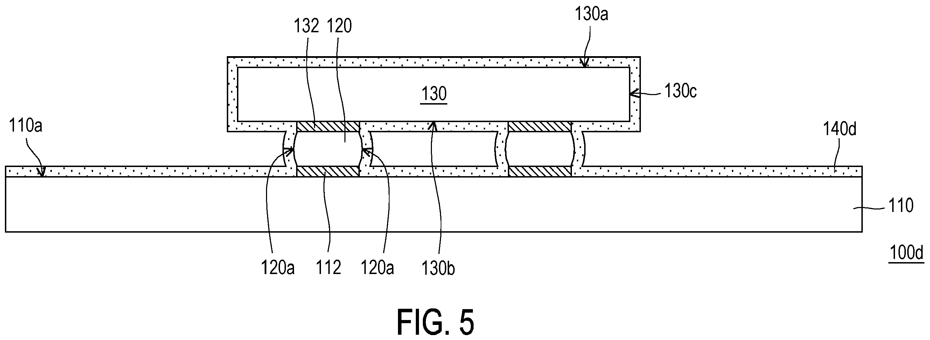

FIG. 5 is a cross-sectional schematic view of an electronic device according to an embodiment of the disclosure. With reference to FIG. 2B and FIG. 5 together, an electronic device 100d in this embodiment is similar to the electronic device 100a in FIG. 2B, but the difference therebetween is that: in the electronic device 100d of this embodiment, an adhesive layer 140d may also be disposed on the upper surface 130a and the side surface 130c of the chip 130.

To be specific, with reference to FIG. 5, in this embodiment, when the adhesive layer 140d is, for example, parylene, the adhesive layer 140d may evenly cover the surfaces (including the upper surface 130a, the lower surface 130b, and the side surface 130c) of the chip 130, the two lateral sides 120a of the bump 120, and the surface 110a of the substrate 110 to protect the chip 130, the bump 120, and the substrate 110. Since parylene is a conformal coating material or a vacuum deposition coating, the adhesive layer 140d has a uniform thickness. Furthermore, the parylene can have, for example, the properties of the N-type, C-type, D-type, or HT-type, but it is not limited thereto.

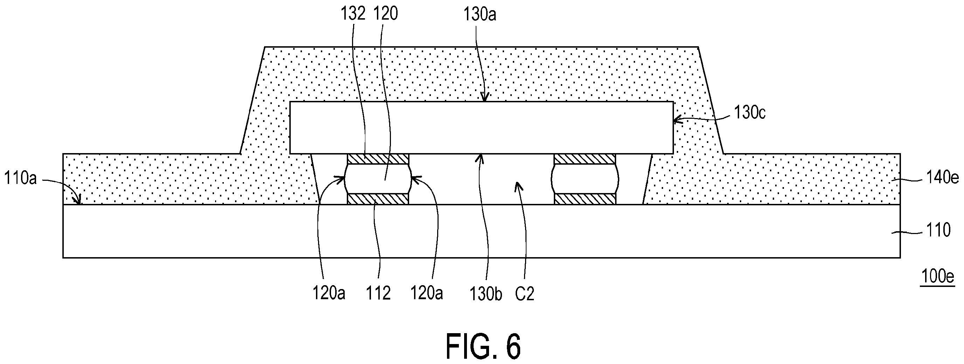

FIG. 6 is a cross-sectional schematic view of an electronic device according to an embodiment of the disclosure. With reference to FIG. 5 and FIG. 6 together, an electronic device 100e of this embodiment is similar to the electronic device 100d in FIG. 5, but the difference therebetween is that: in the electronic device 100e of this embodiment, an adhesive layer 140e does not cover the lateral sides 120a of the bump 120.

To be specific, with reference to FIG. 6, in this embodiment, when the adhesive layer 140e is, for example, a sheet molding compound, a vacuum heating method is required to make the adhesive layer 140e evenly cover the surfaces (including the upper surface 130a, part of the lower surface 130b, and the side surface 130c) of the chip 130 and the surface 110a of the substrate 110 to protect the chip 130, the bump 120, and the substrate 110. In some embodiments that are not shown, the adhesive layer may not cover the lower surface 130b of the chip 130 and is flush with the side surface 130c of the chip 130. That is, the adhesive layer disposed on the substrate 110 may also extend directly from the substrate 110 through the side surface 130c of the chip 130 and to the upper surface 130a of the chip 130.

In this embodiment, a cavity C2 may be surrounded and defined by two adjacent bumps 120, the chip 130, and the substrate 110. The cavity C2 may expose the bump 120, the first connection pad 112, and the second connection pad 132. In the cavity C2, it can be air or vacuum.

In view of the foregoing, in the electronic device and the manufacturing method thereof provided by the disclosure, by arranging the adhesive layer between the substrate and the chip, the bonding strength and stability between the chip and the substrate may be increased. Since the two lateral sides of the bump may be surrounded by the adhesive layer, the contact between the bump and water and oxygen is reduced, and the reliability of the electronic device may thus be improved. In addition, in this embodiment, since the dissipation factor of the adhesive layer can be less than or equal to 0.01 at a frequency of 10 GHz, the electronic device is suitable for high frequency or radio signal transmission. In addition, in some embodiments, since the dielectric constant of the adhesive layer can be less than or equal to 3.8 at a frequency of 10 GHz, the electronic device is suitable for high frequency or radio signal transmission.

## Claims

1. An electronic device (100, 100a, 100b, 100c, 100d, 100e), comprising:
a substrate (110), comprising a first connection pad (112);
a bump (120), disposed on the first connection pad (112);
a chip (130), comprising a second connection pad (132), wherein the bump (120) is disposed between the first connection pad (112) and the second connection pad (132); and
an adhesive layer (140, 140a, 140b, 140c, 140d, 140e), disposed between the substrate (110) and the chip (130), wherein a dissipation factor of the adhesive layer (140, 140a, 140b, 140c, 140d, 140e) is less than or equal to 0.01 at a frequency of 10GHz.

2. The electronic device (100, 100a, 100b, 100c, 100d, 100e) according to claim 1, wherein a dielectric constant of the adhesive layer (140, 140a, 140b, 140c, 140d, 140e) is less than or equal to 3.8 at a frequency of 10GHz.

3. The electronic device (100d, 100e) according to claim 1, wherein the adhesive layer (140d, 140e) is further disposed on an upper surface (130a) and a side surface (130c) of the chip (130).

4. The electronic device (100b) according to claim 1, further comprising:
at least one spacer (144), disposed in the adhesive layer (140b).

5. The electronic device (100b) according to claim 4, wherein the at least one spacer (144) overlaps the chip (130) in a normal direction of the substrate (110).

6. The electronic device (100, 100a, 100b, 100c, 100d, 100e) according to claim 1, wherein a material of the adhesive layer (140, 140a, 140b, 140c, 140d, 140e) comprises at least one of alkane, olefin, ether, nitro, dimethylamine, and parylene.

7. The electronic device (100c) according to claim 1, further comprising:
a redistribution layer (160), disposed between the substrate (110) and the first connection pad (112); and
an electronic element (170), disposed in the redistribution layer (160), wherein the adhesive layer (140c) covers the redistribution layer (160) and the electronic element (170).

8. The electronic device (100, 100b, 100c, 100e) according to claim 1, wherein the adhesive layer (140, 140b, 140c, 140e) does not cover two lateral sides of the bump (120).

9. The electronic device (100a, 100d, 100e) according to claim 1, further comprising:
a cavity (C1, C2), surrounded and defined by the bump (120), the chip (130), and the substrate (110).

10. A manufacturing method of an electronic device (100, 100a, 100b, 100c, 100d, 100e), comprising:
providing a substrate (110), wherein the substrate (110) comprises a first connection pad (112);
applying an adhesive layer (140, 140a, 140b, 140c, 140d, 140e) on the substrate (110);
patterning the adhesive layer (140, 140a, 140b, 140c, 140d, 140e), such that the adhesive layer (140, 140a, 140b, 140c, 140d, 140e) produces an opening exposing the first connection pad (112);
forming a bump (120) on the first connection pad (112);
providing a chip (130), wherein the chip (130) comprises a second connection pad (132); and
bonding the chip (130) onto the bump (120) through the second connection pad (132).

11. The manufacturing method of the electronic device (100, 100a, 100b, 100c, 100d, 100e) according to claim 10, wherein the bump (120) is formed on the first connection pad (112) through a printing process or an inkjet printing process.

12. The manufacturing method of the electronic device (100, 100a, 100b, 100c, 100d, 100e) according to claim 10, wherein a method of patterning is one of a photolithography method, a laser drilling method, a screen printing method, and a spin method.

13. The manufacturing method of the electronic device (100, 100a, 100b, 100c, 100d, 100e) according to claim 10, wherein a dissipation factor of the adhesive layer (140, 140a, 140b, 140c, 140d, 140e) is less than or equal to 0.01 at a frequency of 10GHz.

14. The manufacturing method of the electronic device (100, 100a, 100b, 100c, 100d, 100e) according to claim 10, wherein a dielectric constant of the adhesive layer (140, 140a, 140b, 140c, 140d, 140e) is less than or equal to 3.8 at a frequency of 10GHz.

15. The manufacturing method of the electronic device (100, 100a, 100b, 100c, 100d, 100e) according to claim 10, wherein the step of applying the adhesive layer (140, 140a, 140b, 140c, 140d, 140e) precedes the step of forming the bump (120).
